# EUROPEAN PATENT APPLICATION

(11) **EP 4 624 948 A1**
(43) Date of publication of application: **01.10.2025**
(21) Application number: 24165732.9
(22) Date of filing: 25.03.2024
(51) Int. Cl.: G01R 31/28, G01R 31/317, G06F 1/26

(54) **TEST AND/OR MEASUREMENT SYSTEM AND METHOD OF OPERATING A TEST AND/OR MEASUREMENT SYSTEM**

(71) Applicant: Rohde & Schwarz GmbH & Co. KG, 81671 München (DE)
(72) Inventor: Weigell, Philipp, Dr., 82065 Baierbrunn (DE); Kunisch, Sascha, 63808 Haibach (DE)
(74) Representative: Rupp, Christian

(57) **Abstract**

The disclosure relates to a test and/or measurement system (10). The system (10) comprises: a number of measurement devices (11), wherein each of the number of measurement devices (11) is capable of carrying out one or more measurement tasks with a respective device-under-test, DUT (20); a database (12) configured to store device specific data on the number of measurement devices (11); a communication interface (14) configured to receive information on an external power supply for supplying the number of measurement devices (11); a scheduler module (13) configured to generate a schedule for a plurality of measurement tasks to be carried out with the number of measurement devices (11) on the basis of the device specific data and the received information; and a configuration module (15) configured to control the number of measurement devices (11) to carry out the plurality of measurement tasks according to the schedule.

## Description

### TECHNICAL FIELD

The present disclosure relates to a test and/or measurement system which allows for a more energy-efficient operation.

### BACKGROUND

Test and measurement (T&M) instruments, such as oscilloscopes or signal analyzers, are used for conducting measurements with devices-under-test (DUT). For instance, T&M instruments are used for conformance testing of a DUT, e.g., to test if the DUT complies with predefined standards and specifications. Such tests can consist of many individual measurements and can therefore be very energy intensive.

The costs for operating such T&M instruments can vary strongly over time, e.g., due to a time-variable electricity price. This can lead to increased costs if a T&M instrument has a high power consumption at unfavorable times.

### SUMMARY

Thus, it is an objective to provide an improved test and/or measurement system and an improved method of operating a test and/or measurement system which avoid the above-mentioned disadvantages.

The objective is achieved by the solution provided in the enclosed independent claims. Advantageous implementations of the present disclosure are further defined in the dependent claims.

According to a first aspect, the present disclosure relates to a test and/or measurement system. The test and/or measurement system comprises: a number of measurement devices, wherein each of the number of measurement devices is capable of carrying out one or more measurement tasks with a respective device-under-test (DUT); a database which is configured to store device specific data on the number of measurement devices; a communication interface configured to receive information on an external power supply for supplying the number of measurement devices; a scheduler module configured to generate a schedule for a plurality of measurement tasks to be carried out with the number of measurement devices on the basis of the device specific data and the received information; and a configuration module configured to control the number of measurement devices to carry out the plurality of measurement tasks according to the schedule.

This provides the advantage that the plurality of measurement tasks can be carried out in an energy and cost-efficiency manner. For example, the measurement tasks can be scheduled according to an availability and/or a state of the power supply (e.g., according to the available resources or to a time-variable energy costs). In this way, significant cost savings can be achieved.

The test and/or measurement system can be a measurement platform which comprises one or more measurement devices.

The DUT(s) can be active or a passive communication device(s). For instance, the DUT(s) can comprise an RF port for connecting to one or more of the measurement devices.

A measurement device can be any device that is capable of carrying out a measurement task with a DUT. For instance, a measurement device can be a test and/or measurement instrument, such as an oscilloscope or a signal analyzer.

The number of measurement devices can comprise one or more devices. Depending on the number and/or type of the measurement devices, the system can perform measurements with a single DUT or with multiple DUTs in parallel.

A measurement task may refer to a full measurement of the DUT(s) or to a single step in a multi-step measurement of the DUT(s). In other words, a measurement with the DUT(s) can comprise a plurality of measurement tasks. For instance, one measurement task can be a generation of an RF test signal, a further measurement task can be a receiving of an RF response signal, and yet another measurement task can be an analysis of a signal (e.g., of the RF response signal).

The external power supply can be a mains power supply from the public grid or a power supply from a power generation directly at the site where the system is operated (e.g., from local solar cells). The external power supply can provide its electrical power at variable costs and/or in variable amounts (e.g., in case of solar cells) over time.

The communication interface can be communicatively connected to a building management system (or a similar system) which forwards the information on the external power supply to the communication interface. The communication interface could also be connected to a communication network, e.g. the internet, to receive said information.

The scheduler module and/or the configuration module can be implemented by a computing device or more specifically by a processor of a computing device.

In an embodiment, the device specific data comprises for at least one of the measurement devices: information on power consumptions when carrying out at least one of the measurement tasks, and/or information on time consumptions of at least one of the measurement tasks. In this way, the measurement tasks can be scheduled to align their power consumptions to the availability of the external power supply.

For instance, the device specific data comprises for each of the measurement devices: information on power consumptions when carrying out the one or more measurement tasks, and/or information on time consumptions of the one or more measurement tasks.

The device specific data can further comprise: information on scheduled services and/or an end of lifetime of the measurement device(s). The scheduler module can further consider this information when generating the schedule. In this way, a health and utilization management (HUMS) of the measurement devices can be implemented.

In an embodiment, the information received with the communication interface comprises: information on available energy resources of the external power supply; information on a total available power provided by the external power supply, in particular over time; information on a power consumption of other consumers which are supplied by the external power supply; and/or information on a cost of power which is provided by the external power supply, in particular as a function of time. This achieves the advantage that the measurement tasks can be aligned to the availability and/or costs of the electrical power at a respective site where the system is operated.

In an embodiment, the generated schedule defines a queue for the plurality of measurement tasks to be carried out with the number of measurement devices.

In an embodiment, the number of measurement devices comprise at least one signal-emitting measurement device and/or at least one signal-receiving measurement device.

A signal-emitting measurement device can emit a test signal (e.g., an RF test signal) for testing a DUT. Alternatively or additionally, a signal-emitting measurement device can emit a power signal for powering the DUT at least temporarily (e.g., as part of a measurement routine for the DUT).

In an embodiment, at least one of the number of measurement devices comprises a respective RF port arranged for being connected to the DUT; wherein the RF port is configured to forward an RF (radio frequency) signal generated by the measurement device to the DUT or to receive an RF signal from the DUT.

In an embodiment, the plurality of measurement tasks in the schedule comprise: at least one signal generation and/or signal reception by at least one of the number of measurement devices, and at least one signal analysis by at least one of the number of measurement devices.

In an embodiment, the system further comprises an interface configured to receive information on the measurement tasks to be carried out.

For instance, this information can be on the measurement tasks in general and/or on dependencies or orders of measurement tasks. The interface can be a user or a data interface.

In an embodiment, at least one of the measurement devices comprises a power measurement unit configured to measure a power consumption of the measurement device when carrying out the one or more measurement tasks.

In an embodiment, the at least one measurement device comprises a display configured to display the measured power consumption.

The display can display further information with regards to power consumption, such as energy saving tips.

In an embodiment, the at least one measurement device comprises a processor configured to execute a machine learning (ML) algorithm to learn information on power requirements of the individual measurement tasks over time, wherein the at least one measurement device is configured to forward said information to the database.

In an embodiment, at least the scheduler module and the configuration module are external to the number of measurement devices, wherein the configuration module is connected to the number of measurement devices via a communication connection.

In an embodiment, the test and/or measurement system further comprises: a server, in particular a cloud server, which is communicatively connected to the number of measurement devices, wherein the server comprises the scheduler module and/or the configuration module.

The server can further comprise or be connected to the database. The communication interface can be an interface of the server.

In an embodiment, the components of the test and/or measurement system are housed in or on a common housing.

For example, the test and/or measurement system is a single device, e.g., a test and/or measurement instrument.

According to a second aspect, the present disclosure relates to a method of operating a test and/or measurement system which comprises a number of measurement devices, wherein each of the number of measurement devices is capable of carrying out one or more measurement tasks with a respective device-under-test (DUT). The method comprises: storing device specific data on the number of measurement devices in a database; receiving information on an external power supply for supplying the number of measurement devices; generating a schedule for a plurality of measurement tasks to be carried out with the number of measurement devices on the basis of the device specific data and the received information; and controlling the number of measurement devices to carry out the plurality of measurement tasks according to the schedule.

### BRIEF DESCRIPTION OF THE DRAWINGS

The above described aspects and implementations are explained in the following description of embodiments with respect to the enclosed drawings:
- Fig. 1: shows a test and/or measurement system according to an embodiment;
- Fig. 2: shows a test and/or measurement system according to an embodiment;
- Fig. 3: shows a test and/or measurement system according to an embodiment; and
- Fig. 4: shows a method of operating a test and/or measurement system according to an embodiment.

### DETAILED DESCRIPTION OF EMBODIMENT

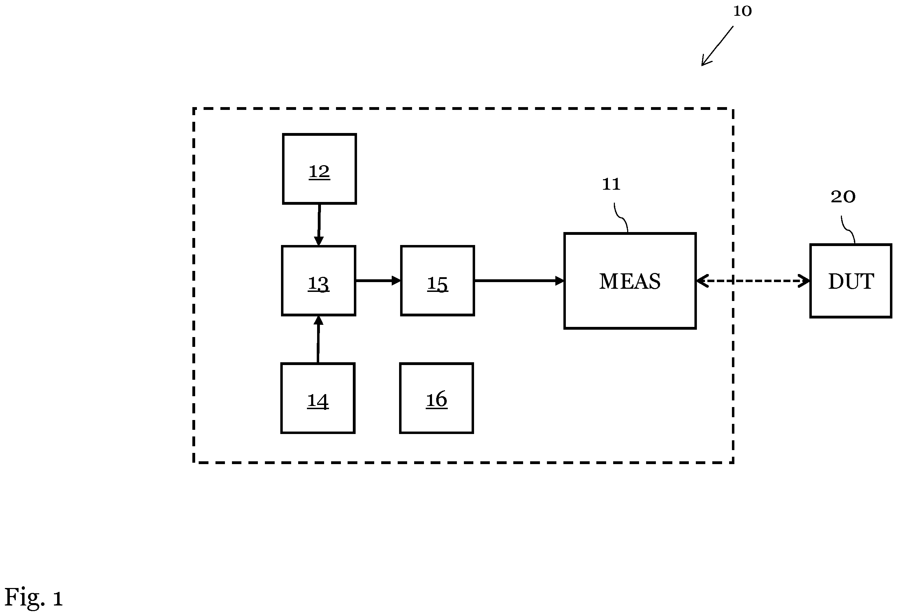

Fig. 1 shows a test and/or measurement system 10 according to an embodiment.

The test and/or measurement system 10 comprises: a number of measurement devices 11, wherein each of the number of measurement devices 11 is capable of carrying out one or more measurement tasks with a respective device-under-test (DUT) 20; a database 12 which is configured to store device specific data on the number of measurement devices 11; a communication interface 14 configured to receive information on an external power supply for supplying the number of measurement devices 11; a scheduler module 13 configured to generate a schedule for a plurality of measurement tasks to be carried out with the number of measurement devices 11 on the basis of the device specific data and the received information; and a configuration module 15 configured to control the number of measurement devices 11 to carry out the plurality of measurement tasks according to the schedule.

The test and/or measurement system 10 can form a test and/or measurement platform for testing and/or measuring DUTs 20. For instance, tests which require a plurality of individual measurement tasks or steps (e.g., conformance tests) can be carried out with the system 10.

For example, each measurement device 11 can be a T&M (test and/or measurement) instrument, such as an oscilloscope or signal analyzer, or can be comprised by a T&M instrument.

The external power supply can be a mains power supply from the public grid or a power supply from a power generation directly at the site where the system is operated (e.g., from local solar cells). The external power supply can provide its electrical power at variable costs and/or in variable amounts (e.g., in case of solar cells) over time.

Thus, by scheduling the measurement tasks according to information on this external power supply, significant cost savings and/or higher usage of renewable sources can be achieved. This is especially important for large installed bases in production environments, where CO₂ certificates can subsequently be sold.

By controlling the measurement device(s) 11 according to the schedule, the configuration module 15 can thus align the measurement tasks to the available energy resources.

The schedule can define a time and a duration for each measurement task and/or a certain sequence of the measurement tasks. The schedule can be a measurement schedule.

The test and/or measurement system 10 can comprise one or more measurement devices 11. In case of a plurality of measurement devices 11, the configuration module 15 can form a central control instance for controlling the plurality of measurement devices 11 to achieve an optimal usage of the measurement devices 11 under consideration of the measurement tasks to be carried out and the parameters of the external power supply.

The DUT 20 can be an active or a passive communication device. For instance, each DUT 20 can comprise an RF port for connecting to one or more of the measurement devices 11.

A measurement task may refer to a full measurement of the DUT(s) 20 or to a single step in a multi-step measurement of the DUT(s) 20. In other words, a measurement with the DUT(s) 20 can comprise a plurality of measurement tasks. For instance, one measurement task can be a generation of an RF test signal, a further measurement task can be a receiving of an RF response signal, and yet another measurement task can be an analysis of a signal (e.g., of the RF response signal).

The measurement tasks can be carried out in the context of a testing of the DUT(s) 20 (e.g., a conformance testing or the like). As such, each measurement device can also be understood as a test device or as a test and/or measurement device.

Optionally, the system 10 can comprise an interface 16 configured to receive information on the measurement tasks to be carried out. For instance, this interface 16 can be a user interface or a data interface. Via this interface 16, an operator or user of the system 10 can incorporate certain test and/or measurement parameters (e.g., dependencies or order of tests).

The interface 16 can be a component of the scheduling module 13 or the configuration module 15.

The scheduler module 13 and/or the configuration module 15 can be implemented as hardware and/or software. For example, the scheduler module 13 and/or the configuration module 15 can be formed by respective processors (or by a single processor) of a measurement device 11 or an external computing device.

The database 12 can be stored in a memory or data storage, e.g. a memory or data storage of a measurement device 11 or an external memory or data storage. The database 12 can store fundamental equipment data of each measurement device 11.

The communication interface 14 can be connected to a building management system to receive the information on the external power supply. The communication interface 14 could also be connected to a communication network, e.g. the internet, to receive said information. For example, the communication interface 14 is an Ethernet or a USB interface.

For instance, the test and/or measurement system 10 can be used in a smart factory environment.

The device specific data stored in the database 12 can comprise: information on power consumptions when carrying out the one or more measurement tasks, and/or information on time consumptions of the one or more measurement tasks. Here, the time consumption may refer to the duration of the measurement task(s).

The device specific data in the database 12 may further comprise: SCIPI commands for controlling the measurement device(s) 11, maintenance times and/or intervals of the measurement device(s) 11, device feature sets, and information on scheduled services or an end of lifetime of the measurement device(s).

By further considering health related data (e.g., scheduled services / end of lifetime), the scheduler module 15 can schedule the measurement tasks to optimize a health and utilization of the measurement device(s) 11.

The information received with the communication interface 14 can comprise: information on available energy resources of the external power supply; information on a total available power provided by the external power supply, in particular over time; and/or information on a power consumption of other consumers which are supplied by the power supply or of the whole building or factory. In addition or alternatively, the received information can comprise information on a cost of power which is provided by the power supply, in particular as a function of time.

Thus, the scheduler module 13 can schedule the measurement tasks according to the expected availability and/or costs of the electrical power at a respective site where the system 10 is operated. In this way, significant cost savings can be achieved. For instance, power intensive measurement tasks can be scheduled at times of the day during which the electricity costs are lower or a higher amount of electricity is produced at the operator site (e.g., via solar cells).

The schedule generated by the scheduler module 13 can define a queue for the plurality of measurement tasks to be carried out with the number of measurement devices 11. Besides measurement tasks themselves, the schedule or more specifically the queue can contain maintenance times and intervals and/or idle times of the measurement devices 11.

The number of measurement devices 11 can comprise at least one signal-emitting measurement device and/or at least one signal-receiving measurement device.

A signal-emitting measurement device can emit a test signal (e.g., an RF test signal) for testing a DUT. Alternatively or additionally, a signal-emitting measurement device can emit a power signal for powering the DUT at least temporarily (e.g., as part of a measurement of the DUT). A signal-receiving measurement device can be configured to receive test signals to be analyzed.

For example, at least one of the number of measurement devices 11 comprises a respective RF port arranged for being connected to the DUT 20. The RF port can be configured to forward an RF signal generated by the measurement device 11 to the DUT 20 or to receive an RF (response) signal from the DUT 20.

The RF port can be a component of or connected to a capture unit of the measurement device 11. The capture unit can be a device component configured to capture a measurement signal (e.g., an RF signal).

For example, the plurality of measurement tasks in the schedule comprise: at least one signal generation and/or signal reception by at least one of the number of measurement devices, and at least one signal analysis by at least one of the number of measurement devices.

For example, the power requirements of a measurement device 11 during signal generation and signal analysis can be quite different (e.g., signal generation requires significantly more power than signal analysis). The scheduling module 13 can separate (or decouple) these tasks to increase the overall energy efficiency. For instance, the scheduling module 13 can schedule an energy intensive signal generation at times when the cost of electricity is lower, and a less energy intensive signal analysis at times when the cost of electricity will be higher.

In an example, the number of measurement devices 11 comprise at least one power supply device which is configured to supply a DUT 20 with an electrical output signal (e.g., as part of a measurement routine for the DUT 20). The electrical output signal can thereby conform to a specific waveform. The power supply device can further be capable of measuring the power needed for the measurement task.

Thus, the scheduler module 13 can also schedule power supply tasks based on their required power and time consumption. In this way, the power consumption of the system 10 can be adapted to the parameters of the external power source, e.g., to achieve cost savings.

For example, a power supply device comprises: a pre-regulator adapted to generate an auxiliary signal by regulating an input signal; a post-regulator adapted to provide an output signal by regulating the auxiliary signal generated by the pre-regulator; and a processing unit adapted to provide a first arbitration signal to the pre-regulator and to provide a second arbitration signal to the post-regulator, wherein the pre-regulator is adapted to regulate the input signal based on the first arbitration signal, wherein the post-regulator is adapted to regulate the auxiliary signal based on the second arbitration signal. The second arbitration signal can comprise a time delay relative to the first arbitration signal; wherein the first arbitration signal and the second arbitration signal are chosen such that a voltage of the auxiliary signal being generated by the pre-regulator is higher than a voltage of the output signal being provided by the post-regulator. For instance, such a power supply device can provide an output signal which corresponds precisely to a predetermined waveform.

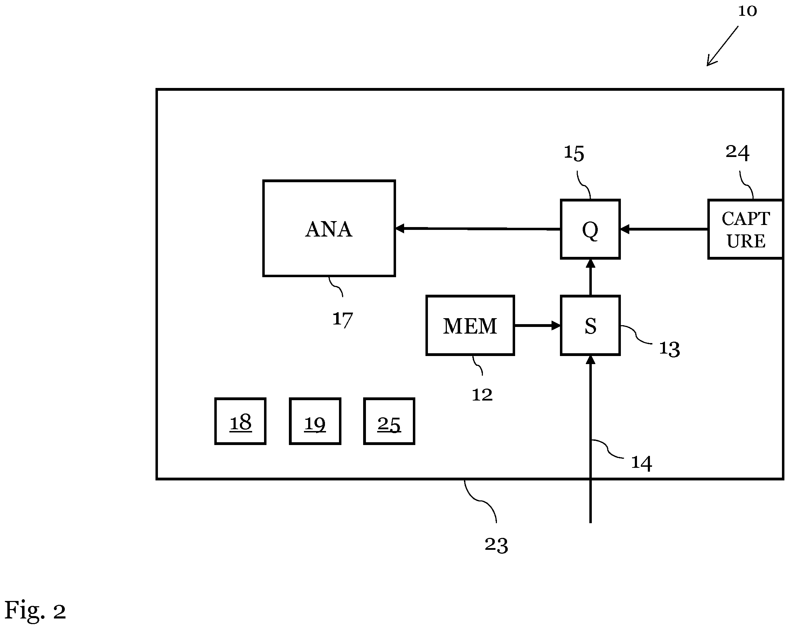

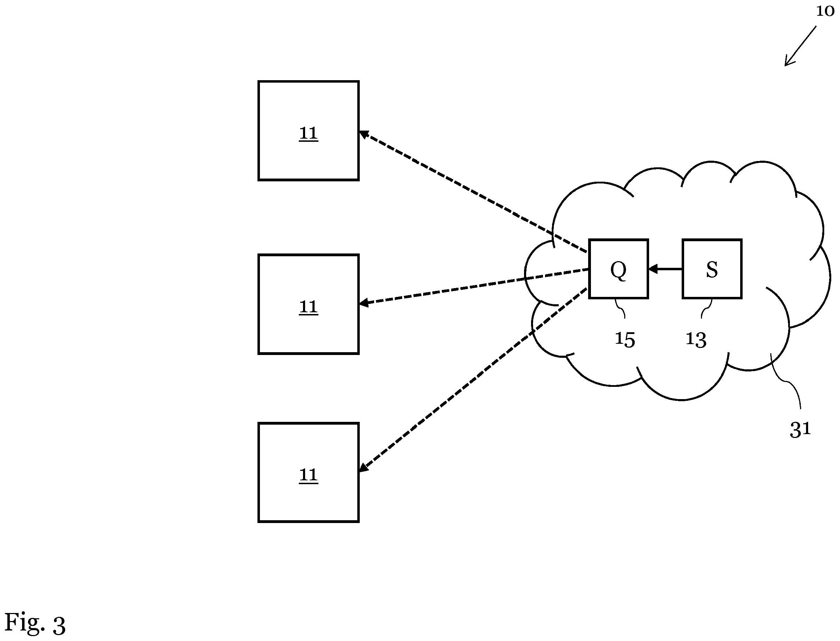

Figs 2 and 3 show exemplary embodiments of the test and/or measurement system 10, which build on the test and/or measurement system 10 shown in Fig. 1. Same elements are labelled with the same reference signs. Hereinafter, only the differences between Fig. 1 and Figs. 2 to 3 are explained.

In the exemplary embodiment shown in Fig. 2, the test and/or measurement system comprises one measurement device 11, wherein all components of the test and/or measurement system 10 are arranged in or on a housing of 23 of the device 11.

Thus, in this example, the system 10 is formed by a single device. This single device can be a test and/or measurement instrument, e.g. an oscilloscope or a signal analyzer.

The exemplary measurement device 11 comprises a capture unit 24 and an analysis unit 17. The capture unit 24 can comprise the RF port and can be configured to capture an RF signal from the DUT 20. The signal analysis unit 17 can be configured to analyze a received RF signal.

The communication interface 14 can be formed by an interface on the device housing 23, e.g. an Ethernet, USB, or GPIB interface.

The database can be stored in a memory of the measurement device 11, and the configuration module 15 and the scheduler module 13 can be implemented by a processor, e.g. a microprocessor or ASIC, of the measurement device 11.

The scheduling module 13 can generate a queue to schedule analysis and/or capture tasks. The queue generation and/or the execution of the measurement task according to the queue can be prompted by a simple trigger or can be carried out according to and external planning.

In this way, a test and/or measurement instrument with an improved power management can be provided.

In the example shown in Fig. 2, the measurement instrument 11 further comprises a power measurement unit 18 which is configured to measure a power consumption of the measurement device 11 when carrying out the one or more measurement tasks. For instance, the power measurement unit 18 can be a power meter.

The power measurement unit 18 can measure a power consumption of the device 11 in different ways:
- 1) By a measurement of fan speeds and temperature points, as essentially the entire received power will be dissipated via the fan. Therefore, the air mass and the temperature are the decisive parameters for calculating the power consumption. The estimated value can be empirically improved via a measured power consumption on the primary side.
- 2) By a measurement of currents on a secondary side supply voltage under consideration of the efficiency of a power adapter (which is known).
- 3) By a "real" primary side measurement of the power (which is supported by the power adapter).

The measurement device 11 can further comprise a display 19 for displaying the measured power consumption.

For instance, the display 19 can show a current power consumption and/or energy savings tips (for example: "when deactivating a particular function, the power consumption can be reduced from 500 W to 400 W").

The display 19 can further offer a dialog in which standby or shutdown rules can be defined (e.g., by specifying inactivity times). To receive such input, the measurement device 11 can comprise a user interface.

The measurement device 11 can further comprise a processor 25 configured to execute a machine learning (ML) algorithm. The ML algorithm can (over time) learn information on power requirements of the individual measurement tasks which are carried out by the measurement device 11. For instance, the ML algorithm can learn how much power certain measurement tasks require and/or which times (of the day) are most suitable for certain measurement tasks.

The measurement device 11 can forward said learned information to the database 12.

In Fig. 2, the capture unit 24, the analysis unit 17, the power measurement unit 18, the display 19 and the processor 25 executing the ML algorithm are shown for an exemplary test and/or measurement system 10 which is formed by a single device. However, each of these elements 24, 17, 18, 19, 25 can also be comprised by at least one of the measurement devices 11 in a system 10 as e.g. shown in Fig. 1 or Fig. 3.

In the exemplary embodiment shown in Fig. 3, the test and/or measurement system 10 comprises a plurality of measurement devices 11, wherein at least the scheduler module 13 and the configuration module 15 are external to the measurement devices 11.

The configuration module 15 can be connected to the number of measurement devices 11 via a communication connection or link.

For instance, the system 10 can further comprise a server 31, such as a cloud server, wherein the server comprises and/or executes the scheduler module 13 the configuration module 15.

The server 31 can be communicatively connected to the number of measurement devices 11 e.g. via a communication network.

For example, the database 12 can be a data storage connected of the server and the communication interface 14 can be an interface of the server 31.

In principle, every system 10 component with the exception of the capture unit 24 for capturing a measurement signal (e.g., the RF port) could be external to the measurement device(s) 11.

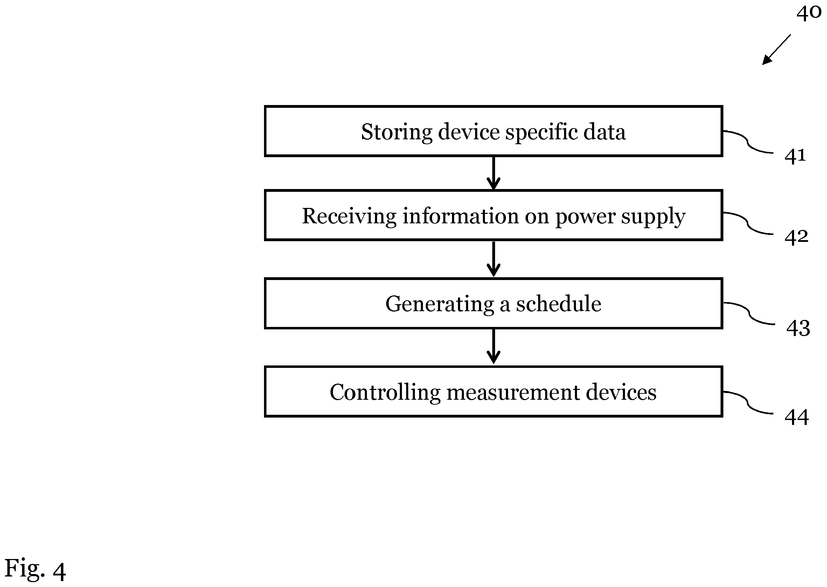

Fig. 4 shows a method 40 of operating a test and/or measurement system 10 according to an embodiment. The test and/or measurement system comprises the number of measurement devices 11, wherein each of the number of measurement devices 11 is capable of carrying out one or more measurement tasks with a respective DUT 20.

The method 40 comprises the steps of: storing 41 device specific data on the number of measurement devices in a database; receiving 42 information on an external power supply for supplying the number of measurement devices; generating 43 a schedule for a plurality of measurement tasks to be carried out with the number of measurement devices on the basis of the device specific data and the received information; and controlling 44 the number of measurement devices to carry out the plurality of measurement tasks according to the schedule.

For instance, the method 40 can be used to operate any one of the test and/or measurement systems 10 as shown in Figs. 1 to 3.

## Claims

1. A test and/or measurement system (10), comprising:
a number of measurement devices (11), wherein each of the number of measurement devices (11) is capable of carrying out one or more measurement tasks with a respective device-under-test, DUT (20);
a database (12) configured to store device specific data on the number of measurement devices (11);
a communication interface (14) configured to receive information on an external power supply for supplying the number of measurement devices (11);
a scheduler module (13) configured to generate a schedule for a plurality of measurement tasks to be carried out with the number of measurement devices (11) on the basis of the device specific data and the received information; and
a configuration module (15) configured to control the number of measurement devices (11) to carry out the plurality of measurement tasks according to the schedule.

2. The test and/or measurement system (10) of claim 1,
wherein the device specific data comprises for at least one of the measurement devices (11):
- information on power consumptions when carrying out at least one of the measurement tasks, and/or
- information on time consumptions of at least one of the measurement tasks.

3. The test and/or measurement system (10) of claim 1 or 2,
wherein the information received with the communication interface (14) comprises:
- information on available energy resources of the external power supply,
- information on a total available power provided by the external power supply, in particular over time,
- information on a power consumption of other consumers which are supplied by the external power supply, and/or
- information on a cost of power which is provided by the external power supply, in particular as a function of time.

4. The test and/or measurement system (10) of any one of the preceding claims,
wherein the generated schedule defines a queue for the plurality of measurement tasks to be carried out with the number of measurement devices (11).

5. The test and/or measurement system (10) of any one of the preceding claims,
wherein the number of measurement devices (11) comprise at least one signal-emitting measurement device and/or at least one signal-receiving measurement device.

6. The test and/or measurement system (10) of any one of the preceding claims,
wherein at least one of the number of measurement devices (11) comprises a respective RF port arranged for being connected to the DUT (20);
wherein the RF port is configured to forward an RF signal generated by the measurement device (11) to the DUT (20) or to receive an RF signal from the DUT (20).

7. The test and/or measurement system (10) of any one of the preceding claims,
wherein the plurality of measurement tasks in the schedule comprise:
- at least one signal generation and/or signal reception by at least one of the number of measurement devices (11), and
- at least one signal analysis by at least one of the number of measurement devices (11).

8. The test and/or measurement system (10) of any one of the preceding claims, further comprising:
an interface (16) configured to receive information on the measurement tasks to be carried out.

9. The test and/or measurement system (10) of any one of the preceding claims,
wherein at least one of the measurement devices (11) comprises a power measurement unit (18) configured to measure a power consumption of the measurement device (11) when carrying out the one or more measurement tasks.

10. The test and/or measurement system (10) of claim 9,
wherein the at least one measurement device (11) comprises a display (19) configured to display the measured power consumption.

11. The test and/or measurement system (10) of claim 9 or 10,
wherein the at least one measurement device (11) comprises a processor (25) configured to execute a machine learning, ML, algorithm to learn information on power requirements of the individual measurement tasks over time;
wherein the at least one measurement device (11) is configured to forward said information to the database (12).

12. The test and/or measurement system (10) of any one of the preceding claims,
wherein at least the scheduler module (13) and the configuration module (15) are external to the number of measurement devices (11);
wherein the configuration module (15) is connected to the number of measurement devices (11) via a communication connection.

13. The test and/or measurement system (10) of any one of the preceding claims, further comprising:
a server (31), in particular a cloud server, which is communicatively connected to the number of measurement devices (11), wherein the server comprises the scheduler module (13) and/or the configuration module (15).

14. The test and/or measurement system (10) of any one of claims 1 to 11,
wherein the components of the test and/or measurement system are housed in or on a common housing (23).

15. A method (40) of operating a test and/or measurement system (10) which comprises a number of measurement devices (11), wherein each of the number of measurement devices (11) is capable of carrying out one or more measurement tasks with a respective device-under-test, DUT (20), the method (40) comprising:
storing (41) device specific data on the number of measurement devices (11) in a database (12);
receiving (42) information on an external power supply for supplying the number of measurement devices (11);
generating (43) a schedule for a plurality of measurement tasks to be carried out with the number of measurement devices (11) on the basis of the device specific data and the received information; and
controlling (44) the number of measurement devices (11) to carry out the plurality of measurement tasks according to the schedule.
